# EUROPÄISCHE PATENTSCHRIFT

(11) **EP 0 660 467 B1**
(45) Veröffentlichungstag und Bekanntmachung des Hinweises auf die Patenterteilung: **19.03.1997**
(21) Anmeldenummer: 93120734.4
(22) Anmeldetag: 22.12.1993
(51) Int. Cl.: H01S 3/025

(54) **Optoelektronisches Bauelement und Verfahren zu dessen Herstellung**
Optoelectronical element and method of making the same
Elément optoélectronique et sa méthode de fabrication

(43) Veröffentlichungstag der Anmeldung: 28.06.1995
(73) Patentinhaber: SIEMENS AKTIENGESELLSCHAFT, 80333 München (DE)
(72) Erfinder: Althaus, Hans Ludwig, Dr. rer. nat., D-93138 Lappersdorf (DE); Dietrich, Ralf, Ing. grad., D-81543 München (DE); Gramann, Wolfgang, D-93057 Regensburg (DE); Späth, Werner, Dipl.-Phys., D-83607 Holzkirchen (DE)

(56) Entgegenhaltungen:
- EP-A- 0 199 565
- GB-A- 2 213 957
- US-A- 4 807 238
- PATENT ABSTRACTS OF JAPAN, Bd. 7, Nr. 200 (E-196) 3. September 1983 & JP-A-58 097 885
- PATENT ABSTRACTS OF JAPAN, Bd. 15, Nr. 125 (E-1050) 27. März 1991 & JP-A-03 011 783
- PATENT ABSTRACTS OF JAPAN, Bd. 13, Nr. 88 (E-721) 28. Februar 1989 & JP-A-63 265 483

## Beschreibung

Die Erfindung betrifft ein optoelektronisches Bauelement mit einem Laserchip als Lichtsender und einer Linsenkoppeloptik zum definierten Abstrahlen der im Laserchip erzeugten optischen Strahlung sowie ein Verfahren zu dessen Herstellung.

Optoelektronische Bauelemente mit einer Linsenkoppeloptik sind bekannt und beispielsweise in EP-A-0 412 184 und US-A-4 807 238 beschrieben.

Derartige Opto-Halbleiterbauelemente dienen insbesondere als Lichtsendebauelemente zum Koppeln an Lichtwellenleiter. Die für die optische Kopplung zwischen einem Halbleiter-Laser und einem Lichtleiter, beispielsweise einer Glasfaser, insbesondere in der optischen Daten- und Nachrichtentechnik verwendeten, bekannten Bauelemente leiden in der Regel darunter, daß sie wegen der Abstrahlung der kohärenten Strahlung des Laserchips von dessen Kante, d.h. in dessen Montageebene, teure Einzelkomponenten und aufwendige Montageprozesse erfordern.

Der Erfindung liegt die Aufgabe zugrunde, ein optoelektronisches Bauelement der eingangs genannten Art derart auszubilden, daß eine unmittelbar vor dem Laserchip angeordnete Linsenkoppeloptik auf einfache Weise justiert und stabil fixiert werden kann und ein besonders rationelles Verfahren zu dessen Herstellung anzugeben, das sowohl eine vereinfachte Montage des Laserchips als auch der mechanischen Verbindungs- und optischen Abbildungselemente im Waferverband ermöglicht.

Diese Aufgabe wird erfindungsgemäß durch ein optoelektronisches Bauelement mit den Merkmalen des Anspruchs 1 und durch ein Verfahren zu dessen Herstellung nach Anspruch 9 gelöst.

Vorteilhafte Ausgestaltungen bzw. Weiterbildungen der Erfindung sind Gegenstand zusätzlicher Ansprüche.

Die mit der Erfindung erzielten Vorteile bestehen insbesondere darin, daß das optoelektronische Bauelement einen Aufbau besitzt, der unter Nutzung von Komponenten und Techniken der Mikromechanik und Mikrooptik sowohl eine vereinfachte Montage des Laserchips auf einem Subträger (Submount) als auch eine besonders rationelle Herstellung einer Vielzahl derartiger Bauelemente im Scheibenverband erlaubt. Dabei können gleichzeitig alle mechanischen Verbindungs- und optischen Abbildungselemente sowie die Laserchips montiert und dann vereinzelt werden. Das optoelektronische Bauelement zeichnet sich durch einen raumsparenden Aufbau, eine mechanisch stabile Linsenkoppeloptik und eine definierte Abstrahlcharakteristik aus.

Anhand eines in den Figuren der Zeichnung dargestellten Ausführungsbeispiels wird die Erfindung im folgenden näher erläutert.
Es zeigen
- FIG 1: ein optoelektronisches Bauelement im Schnitt und
- FIG 2: ein optoelektronisches Bauelement beim Herstellen im Waferverband.

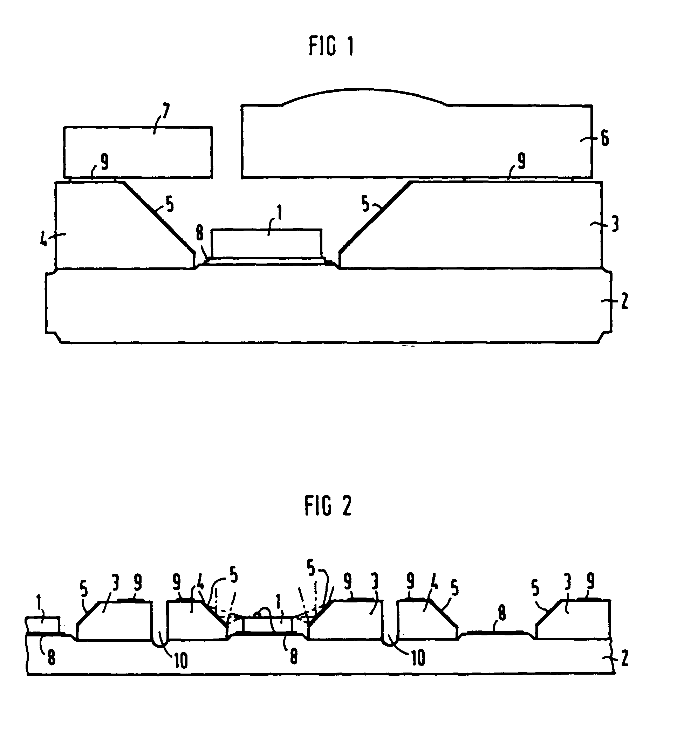

Das in FIG 1 als Einzelbauelement und in FIG 2 im Scheibenverband dargestellte optoelektronische Bauelement besteht im wesentlichen aus einem Laserchip 1 als Lichtsender und einer Linsenkoppeloptik 6 zum definierten Abstrahlen der im Laserchip erzeugten optischen Strahlung. Der Laserchip 1 ist auf einem gemeinsamen Träger 2 angeordnet, der vorzugsweise aus Silizium besteht und als Submount beispielsweise auf die Bodenplatte eines TO-Gehäuses montiert werden kann. Der Laserchip 1 ist auf dem gemeinsamen Träger 2 zwischen zwei Trägerteilen 3, 4 angeordnet, deren den optischen Resonatorflächen des Laserchips 1 benachbarte Seitenflächen mit Spiegelschichten 5 versehen und zu den Resonatorflächen in einem Winkel von 45° geneigt sind, so daß die im Laserchip 1 erzeugte kohärente Strahlung zur Oberfläche des gemeinsamen Trägers 2 nahezu senkrecht nach oben umgelenkt wird. Die beiden Trägerteile 3, 4 bestehen vorzugsweise aus Glas und weisen ein trapezförmiges Profil auf. Insbesondere zur Vereinfachung der Justage und Befestigung dieser beiden Trägerteile 3, 4 ist es vorteilhaft, in dem gemeinsamen Träger 2 hierzu passende Vertiefungen bzw. Gräben vorzusehen, in die die Trägerteile 3, 4 dann eingefügt und darin befestigt sind. Als Spiegelschichten 5 sind auf den benachbarten Seitenflächen der Trägerteile 3, 4 zweckmäßig Schichten aus dielektrischem Material aufgebracht. Auf mindestens dem einen Trägerteil, in diesem Ausführungsbeispiel auf dem Trägerteil 3, ist die Linsenkoppeloptik 6 so angeordnet und befestigt, daß die im Laserchip 1 erzeugte Strahlung auf diese nahezu senkrecht auftrifft.

Die Linsenkoppeloptik 6 ist vorzugsweise ein Linsenchip mit integrierter refraktiver und/oder diffraktiver Linse. Dieser Linsenchip bzw. die Linsenkoppeloptik 6 kann auch den Laserchip 1 überspannend auf beiden Trägerteilen 3, 4 justiert und fixiert sein. Der Linsenchip besteht je nach der vom Laserchip 1 emittierten Wellenlänge zweckmäßig aus einem entsprechend durchlässigen Glas oder Halbleitermaterial wie Silizium, Siliziumkarbid oder Galliumphosphid. Der Linsenchip, der als Linsenkoppeloptik 6 einseitig auf nur einem Trägerteil oder beidseitig auf beiden Trägerteilen 3, 4 angeordnet werden kann, wird vorteilhaft mit seiner strukturierten und/oder gekrümmten Seite nach unten, d.h. dieser dem Laserchip 1 zugewandten Seite auf das eine oder auf beide Trägerteile 3, 4 aufgebracht und befestigt. Eine solche Anordnung ist insbesondere toleranzfreundlicher als eine Anordnung mit äußerer Krümmung bzw. Struktur. Als Linsenkoppeloptik 6 kann außer einem Linsenchip mit integrierter Linse beispielsweise auch eine Kugellinse oder Zylinderlinse verwendet werden, die in einer Öffnung in einem Linsenträger befestigt ist, der z.B. aus Silizium besteht.

Für bestimmte Anwendungen des optoelektronischen Bauelements wird zweckmäßig auf dem einen der beiden Trägerteile 3, 4 oder auf dem Linsenchip, sofern dieser auf beiden Trägerteilen 3, 4 aufgebracht ist, ein Monitor-Chip 7 derart angeordnet und befestigt, daß von diesem ein Teil der vom Laserchip 1 erzeugten optischen Strahlung empfangbar ist. Zu diesem Beispiel ist der Monitorchip 7 auf dem Trägerteil 4 befestigt und empfängt das vom Laserchip 1 emittierte und vom Spiegel 5 reflektierte Laser-Rückseitenlicht.

Gemäß einer besonders vorteilhaften Ausführung des erfindungsgemäßen optoelektronischen Halbleiterbauelementes, das in einem Waferverband gleichzeitig in einer Vielzahl hergestellt werden kann, ist gemäß FIG 1 und 2 eine vorzugsweise aus Silizium bestehende Scheibe als gemeinsamer Träger 2 bzw. Submount mit geeigneten metallischen Strukturen 8 zur Bondung der Laserchips 1 versehen. In diesem Träger 2 werden zweckmäßig parallele Vertiefungen bzw. Gräben beispielsweise von einigen 100µm Breite und Abstand geätzt. Die Grabentiefe kann von einem bis zu einigen 100µm betragen. In diese Vertiefungen oder auf den gemeinsamen Träger 2 direkt werden Trägerteile 3, 4 vorzugsweise in Gestalt von Prismenstreifen mit trapezförmigem Profil, bei dem sich die Verlängerungen der beiden Seitenflächen in einem rechten Winkel schneiden, eingebracht und anodisch oder durch Löttechnik gebondet. Die benachbarten Seitenflächen der Trägerteile 3, 4 sind mit Spiegelschichten 5 versehen. Mit Vorteil werden dielektrische Spiegel aus Schichtfolgen wie SiO₂-TiO₂, SiO₂-Si, Al₂O₃-Si oder Kombinationen dieser Schichtenfolgen oder anderer dielektrischer Schichten angebracht. Die schmalere Oberseite der prismenförmigen Trägerteile 3, 4 kann mit einer lötfähigen Metallschichtstruktur 9 z.B. aus Ti-Pt-Au, Cr-Pt-Au, Ti-Ni-Au, Ti-Pt-AuSn, Ni-Au oder anderen lötfähigen Schichten versehen werden.

Zum Aufbau der Lasereinheit bzw. des optoelektronischen Bauelements werden nun auf die auf dem gemeinsamen Trägerteil (Si-Submount) vorgesehenen Metallpads bzw. metallischen Strukturen 8 die Laserchips 1, die auf der dem Träger 2 zugewandten Unterseite je nach Anforderung mit einer Lotschicht aus AuSn, AuGe, AuSi, PbSn oder anderen lötfähigen Schichten von ca. 1µm bis 10µm Dicke versehen sind, in einem definierten Abstand vor den Trägerteilen 3, 4 festgelötet. Die erforderliche Energie für die Lötung kann durch verschiedene Verfahren, wie HF-Heizung, WIG-Heizung, Heatpipe-Heizung oder durch Laserstrahlung in die zu befestigende Unterseite des Laserchips 1 eingekoppelt werden. Von Vorteil ist es, den gemeinsamen Träger 2 (vorzugsweise Siliziumscheibe) so vorzuheizen, daß die für den Lötvorgang erforderliche Temperatur mit wenig Zusatzenergie erreicht wird. Um diese besonders niedrig zu halten, kann durch bestimmte Maßnahmen, z.B. Einschnitte zwischen den einzelnen Laserchips 1, die von deren Unterseite bis zu den Trägerteilen 3, 4 gehen können, der Abfluß der zugeführten Energie zu den Nachbarchips stark reduziert werden. Die Oberseite des Laserchips 1 wird mit einem dafür vorgesehenen Pad auf dem gemeinsamen Träger 2 verbunden.

Die besondere Ausführung des Lasersubmounts, d.h. des gemeinsamen Trägers 2, mit reflektierenden prismenförmigen Trägerteilen 3, 4 zur Strahlumlenkung ermöglicht es nun, das in der Halbleitertechnik übliche, bisher bei den bekannten Laser-Kantenstrahlern nicht anwendbare Testen auf einem Standardwaferprober mit nur einem zusätzlichen optischen Meßkopf zur Erfassung der optoelektronischen Größen einzusetzen.

Nach der Messung kann die Scheibe (Wafer) wahlweise in die einzelnen Submounts (Träger 2) aufgetrennt werden, wobei jeder Submount (Träger 2) einen Laserchip 1 und je einen Teil der prismenförmigen Trägerteile 3, 4 vor der Vorder- und Rückseite des Laserchips 1 enthält. Das Auftrennen der Scheibe bzw. das Vereinzeln der Bauelemente bzw. deren Submounts geschieht gemäß FIG. 2 längs der Trennspuren 10. Die Aufteilung der Scheibe, vorzugsweise Siliziumscheibe (Träger 2) in einzelne Submounts kann auch bereits vor Montage der Laserchips 1 vorgenommen werden. Die Submounts können dann einzeln weiterverarbeitet werden.

Vor oder nach der Vereinzelung der Submounts wird dann eine Linsenkoppeloptik 6 hier in Gestalt eines Linsenchips, dessen Linse refraktiv und/oder diffraktiv sein kann, aktiv oder passiv, d.h. mit oder ohne Laserbetrieb als Hilfsmittel, über der Spiegelschicht 5 des Trägerteils 3 vor der Vorderseite des Laserchips 1 in x- und y-Richtung justiert und zweckmäßig durch eine Lötung oder Klebung auf der Oberfläche des Trägerteils 3 befestigt. Die erforderliche Energie für die Lötung kann z.B. durch eine Stromdirektheizung des Linsenchips oder durch Strahlungsheizung durch einen Laser (Halbleiter-Leistungslaser, Festkörperlaser, CO₂-Laser usw.) in den Linsenchip eingebracht werden. Das notwendige Lot kann z.B. durch Aufdampfen auf den Linsenchip aufgebracht worden sein, das dann zur Fixierung unter Druckkontakt zur Unterlage (Trägerteil 3) aufgeschmolzen wird. Der Wärmewiderstand des Trägerteils 3, beispielsweise Glasprismas, ist so bemessen, daß nur eine unwesentliche Erwärmung des Materials des Trägers 2, beispielsweise Si-Substrats, beim Lötvorgang erfolgt.

Die Summe der Abstände Vorderseite des Laserchips 1 - Trägerteil 3, Trägerteil 3 - Linsenchip 6 plus optische Dicke der Linse im Linsenchip 6 ergibt die Gegenstandsweite der optischen Abbildung. Diese kann bei festem Abstand Trägerteil 3 - Linsenchip 6 und fester optischer Dicke der Linse im Linsenchip 6 allein über eine Lateralverschiebung, also Änderung des Abstandes der Vorderseite des Laserchips 1 zum Trägerteil 3 hin oder von diesem weg eingestellt bzw. variiert werden. Die z-Justage ist so auf eine einfache Lateraljustage transformiert worden. Damit läßt sich die Abbildung des Laserflecks sehr einfach auf den Kern einer Lichtleitfaser, die sich in einem vorgegebenen Abstand vor der Linse des Linsenchips 6 befindet, einstellen.

Die verwendeten Linsenchips können in einem Scheibenprozeß durch spezielle photolithographische und ätztechnische Prozesse hergestellt werden. Das Linsenmaterial wird je nach den technischen Anforderungen ausgewählt. Für Wellenlängen größer 1,1µm wird mit Vorteil Silizium verwendet, für kürzere Wellenlängen spezielle Gläser oder Halbleitermaterial wie z.B. Galliumphosphid oder Siliziumkarbid. Silizium kann aber auch nur Träger für Linsen sein. Die Verwendung von Silizium ergibt bezüglich Temperaturänderungen einen besonders stabilen Aufbau, da gemeinsamer Träger 2 (Submount), Trägerteile 3, 4 (z.B. Glasprismen) und Linsenkoppeloptik 6 (Linsenchips) in den in Frage kommenden raturintervallen nahezu gleichen Ausdehnungskoeffizienten haben.

Falls erforderlich, kann auf der Oberseite des einen Trägerteils 4, das dem Trägerteil 3 gegenüberliegt, das die senkoppeloptik 6 trägt, eine geeignete Monitordiode 7 in der Weise aufgebracht werden, daß ein Teil der Diode über die auf dem Trägerteil 4 aufgebrachte Spiegelschicht 5 hinausragt. Somit können die aus dem hinteren Spiegel (hintere Resonatorseite) des Laserchips 1 austretenden und an der benachbarten Spiegelschicht 5 nach oben reflektierten Photonen (Rückseitenlicht) über das transparente Substrat des Monitorchips 7 den pn-Übergang der Monitordiode erreichen. Bei Monitordioden mit nichttransparentem Substrat wird die Diode mit dem pn-Übergang nach unten auf das Trägerteil 4 aufgebracht. Der Monitorchip 7 kann aber auch über der Linsenkoppeloptik 6 angeordnet werden oder in ihn integriert sein, sofern sich beispielsweise ein Linsenchip über beide Trägerteile 3, 4 erstreckt.

Nach optoelektronischer Prüfung können die gemeinsamen Träger 2 (Submounts), auf denen sich Laserchip 1, Trägerteile 3 und 4, Linsenkoppeloptik 6 und Monitorchip 7 befinden, also die Mikromodule, wie ein üblicher Halbleiterchip in Die- und Wirebondtechnik auf einen vorgesehenen Gesamtträger, beispielsweise die Bodenplatte eines TO-Gehäuses montiert werden.

Es ist von Vorteil, die Lichteintrittsfläche der Monitordiode 7 und die Linsenkoppeloptik 6, insbesondere die Linse, mit einer optischen Vergütung zur Verminderung der Reflexionsverluste zu versehen.

## Patentansprüche

1. Optoelektronisches Bauelement mit einem Laserchip als Lichtsender und einer Linsenkoppeloptik zum definierten Abstrahlen der im Laserchip erzeugten Strahlung, in dem der Laserchip (1) auf einem gemeinsamen Träger (2) zwischen zwei Trägerteilen (3, 4) angeordnet ist, deren den Resonatorflächen des Laserchips (1) benachbarte Seitenflächen mit Spiegelschichten (5) versehen und zu den Resonatorflächen in einem Winkel von 45° geneigt sind, so daß die im Laserchip (1) erzeugte Strahlung zur Oberfläche des gemeinsamen Trägers (2) nahezu senkrecht nach oben gerichtet ist, und daß auf mindestens dem einen Trägerteil (3) die Linsenkoppeloptik (6) so angeordnet und befestigt ist, daß die im Laserchip (1) erzeugte Strahlung auf diese nahezu senkrecht auftrifft.

2. Bauelement nach Anspruch 1, **dadurch gekennzeichnet,** daß der gemeinsame Träger (2) aus Silizium besteht.

3. Bauelement nach Anspruch 1 oder 2, **dadurch gekennzeichnet,** daß die Trägerteile (3, 4) aus Glas oder aus Silizium bestehen und ein trapezförmiges Profil aufweisen.

4. Bauelement nach einem der Ansprüche 1 bis 3, **dadurch gekennzeichnet**, daß die Trägerteile (3, 4) in Vertiefungen im gemeinsamen Träger (2) eingefügt sind.

5. Bauelement nach einem der Ansprüche 1 bis 4, **dadurch gekennzeichnet,** daß die Spiegelschichten (5) auf den benachbarten Seitenflächen der Trägerteile (3, 4) Schichten aus dielektrischem Material sind.

6. Bauelement nach einem der Ansprüche 1 bis 5, **dadurch gekennzeichnet**, daß die Linsenkoppeloptik (6) ein Linsenchip mit integrierter refraktiver und/oder diffraktiver Linse ist.

7. Bauelement nach Anspruch 6, **dadurch gekennzeichnet**, daß der Linsenchip aus Silizium, Siliziumkarbid, Galliumphosphid oder aus Glas besteht.

8. Bauelement nach einem der Ansprüche 1 bis 7, **dadurch gekennzeichnet**, daß auf dem einen der beiden Trägerteile (3, 4) oder auf der Linsenkoppeloptik (6) ein Monitor-Chip (7) derart angeordnet und befestigt ist, daß von diesem ein Teil der vom Laserchip (1) erzeugten optischen Strahlung empfangbar ist.

9. Verfahren zum Herstellen einer Vielzahl optoelektronischer Bauelemente nach einem der Ansprüche 1 bis 8 im Scheibenverband, **dadurch gekennzeichnet**, daß in eine Silizium-Scheibe als gemeinsamen Träger (2), die mit geeigneten metallischen Strukturen zur Bondung der Laserchips (1) versehen wird, voneinander beabstandete, parallele Vertiefungen eingeätzt werden, daß in diese Vertiefungen als Trägerteile (3, 4) Prismenstreifen mit trapezförmigem Profil eingebracht und anodisch oder durch Löttechnik gebondet werden, deren benachbarte Seitenflächen mit Spiegelschichten (5) versehen sind, daß die Laserchips (1) in einem definierten Abstand vor den Trägerteilen (3, 4) angeordnet und befestigt werden, und daß dann die Silizium-Scheibe in die einzelnen Bauelemente im Bereich der Trägerteile (3, 4) aufgetrennt wird.

10. Verfahren nach Anspruch 9, **dadurch gekennzeichnet**, daß das Vereinzeln der Silizium-Scheibe vor dem Aufbringen der Laserchips (1) vorgenommen wird.

11. Verfahren nach Anspruch 9 oder 10, **dadurch gekennzeichnet**, daß als Linsenkoppeloptik (6) ein Linsenchip über der Spiegelschicht (5) des einen Trägerteils (3) vor der Vorderseite des Laserchips (1) in x- und y-Richtung justiert und durch Lötung oder Klebung auf der Oberfläche des Trägerteils (3) befestigt wird.

12. Verfahren nach einem der Ansprüche 9 bis 11, **dadurch gekennzeichnet**, daß über der Spiegelschicht (5) des zweiten Trägerteils (4) vor der Rückseite des Laserchips (1) ein Monitor-Chip (7) justiert und fixiert wird.

## Claims

1. Optoelectronic component with a laser chip as the light transmitter and with lens coupling optics for defined emission of the radiation produced in the laser chip, in which the laser chip (1) is arranged on a common carrier (2), between two carrier parts (3, 4) whose side faces adjoining the resonator faces of the laser chip (1) are provided with mirror layers (5) and are inclined by an angle of 45° with respect to the resonator faces, so that the radiation produced in the laser chip (1) is directed substantially vertically upwards with respect to the surface of the common carrier (2), and that the lens coupling optics (6) are arranged and fastened on at least one carrier part (3) so that the radiation produced in the laser chip (1) is incident substantially vertically thereon.

2. Component according to Claim 1, characterized in that the common carrier (2) consists of silicon.

3. Component according to Claim 1 or 2, characterized in that the carrier parts (3, 4) consist of glass or silicon and have a trapezoidal profile.

4. Component according to one of Claims 1 to 3, characterized in that the carrier parts (3, 4) are inserted into indentations in the common carrier (2).

5. Component according to one of Claims 1 to 4, characterized in that the mirror layers (5) on the adjoining side faces of the carrier parts (3, 4) are layers of dielectric material.

6. Component according to one of Claims 1 to 5, characterized in that the lens coupling optics (6) are a lens chip with integrated refracting and/or diffracting lens.

7. Component according to Claim 6, characterized in that the lens chip consists of silicon, silicon carbide, gallium phosphide or glass.

8. Component according to one of Claims 1 to 7, characterized in that a monitor chip (7) is arranged and fastened on one of the two carrier parts (3, 4) or on the lens coupling optics (6), in such a way that it can receive a part of the optical radiation produced by the laser chip (1).

9. Method for the production of a plurality of optoelectronic components according to one of Claims 1 to 8 in a wafer matrix, characterized in that spaced-apart parallel indentations are etched into a silicon wafer as the common carrier (2), which is provided with suitable metallic structures for bonding the laser chips (1), in that prismatic strips with trapezoidal profile are introduced as carrier parts (3, 4) into these indentations and are bonded anodically or by soldering, the adjoining side faces of which prismatic strips are provided with mirror layers (5), in that the laser chips (1) are arranged and fastened at a defined distance in front of the carrier parts (3, 4) and in that the silicon wafer is then divided into individual components at the carrier parts (3, 4).

10. Method according to Claim 9, characterized in that the silicon wafer is divided before the laser chips (1) are applied.

11. Method according to Claim 9 or 10, characterized in that, as the lens coupling optics (6), a lens chip is aligned in the x and y directions over the mirror layer (5) of one carrier part (3) in front of the front side of the laser chip (1), and is fastened on the surface of the carrier part (3) by soldering or adhesive bonding.

12. Method according to one of Claims 9 to 11, characterized in that a monitor chip (7) is aligned and fastened over the mirror layer (5) of the second carrier part (4) in front of the back side of the laser chip (1).

## Revendications

1. Composant optoélectronique ayant une puce laser en tant qu'émetteur de lumière et un dispositif optique de couplage à lentille pour émettre de manière définie le rayonnement produit dans la puce laser, dans lequel la puce laser (1) est disposée sur un support commun (2) entre deux parties (3, 4) de support, dont les surfaces latérales voisines des surfaces de résonateur de la puce laser (1) sont munies de couches (5) réfléchissantes et sont inclinées d'un angle de 45° par rapport aux surfaces des résonateurs, de sorte que le rayonnement produit dans la puce laser (1) soit dirigé pratiquement perpendiculairement vers le haut par rapport à la surface du support commun (2) et le dispositif (6) optique de couplage à lentille est disposé et fixé sur au moins l'une (3) des parties de support, de telle sorte que le rayonnement produit dans la puce laser (1) rencontre celui-ci pratiquement à angle droit.

2. Composant suivant la revendication 1, caractérisé en ce que le support commun (2) est en silicium.

3. Composant suivant la revendication 1 ou 2, caractérisé en ce que les parties (3, 4) de support sont en verre ou en silicium et ont un profil trapézoïdal.

4. Composant suivant l'une des revendications 1 à 3, caractérisé en ce que les parties (3, 4) de support sont insérées dans des évidements du support commun (2).

5. Composant suivant l'une des revendications 1 à 4, caractérisé en ce que les couches réfléchissantes (5) sur les surfaces latérales voisines des parties (3, 4) de support sont des couches en un matériau diélectrique.

6. Composant suivant l'une des revendications 1 à 5, caractérisé en ce que le dispositif (6) optique de couplage à lentille est une puce à lentille de réfraction et/ou de diffraction intégrée.

7. Composant suivant la revendication 6, caractérisé en ce que la puce à lentille est en silicium, en carbure de silicium, en phosphure de gallium ou en verre.

8. Composant suivant l'une des revendications 1 à 7, caractérisé en ce qu'une puce (7) de contrôle est disposée et fixée sur l'une des deux parties (3, 4) de support ou sur le dispositif (6) optique de couplage à lentille, de telle sorte qu'une partie du rayonnement optique produit par la puce laser (1) puisse être reçue par celle-ci.

9. Procédé de fabrication d'une multiplicité de composants optoélectroniques suivant l'une des revendications 1 à 8 dans la structure d'une tranche, caractérisé en ce que l'on forme par attaque chimique d'une tranche de silicium en tant que support commun (2), que l'on munit de structures métalliques appropriées pour la soudure des puces laser (1), des évidements parallèles à distance les uns des autres, on met dans ces évidements des bandes prismatiques à profil trapézoïdal en tant que parties (3, 4) de support, on les soude anodiquement ou par une technique de brasage, on munit leurs surfaces latérales voisines de couches réfléchissantes (5), on dispose et on fixe les puces laser (1) à une distance définie devant les parties (3, 4) de support et on coupe ensuite la tranche de silicium dans la zone des parties (3, 4) de support pour former les composants individuels.

10. Procédé suivant la revendication 9, caractérisé en ce que l'on procède à l'individualisation de la tranche de silicium avant de mettre en place les puces laser (1).

11. Procédé suivant la revendication 9 ou 10, caractérisé en ce que l'on ajuste en tant que dispositif (6) optique de couplage à lentille, une puce à lentille au-dessus de la couche (5) réfléchissante de l'une (3) des parties de support devant le côté avant de la puce (1) laser dans les directions x et y et on la fixe sur la surface de la partie (3) de support par brasage ou collage.

12. Procédé suivant l'une des revendications 9 à 11, caractérisé en ce que l'on ajuste et l'on fixe une puce (7) de contrôle au-dessus de la couche (5) réfléchissante de la deuxième partie (4) de support devant le côté arrière de la puce (1) laser.
